# EUROPEAN PATENT APPLICATION

(11) **EP 1 947 671 A2**
(43) Date of publication of application: **23.07.2008**
(21) Application number: 08100160.4
(22) Date of filing: 07.01.2008
(51) Int. Cl.: H01J 17/00

(54) **Plasma Display Device**

(30) Priority: 22.01.2007 KR 20070006544
(71) Applicant: Samsung SDI Co., Ltd., Suwon-si, Gyeonggi-do (KR)
(72) Inventor: Yeo, Jaeyoung c/o Legal & IP Team Samsung SDI Co., Ltd., Gyeonggi-do (KR)
(74) Representative: Walaski, Jan Filip

(57) **Abstract**

A plasma display device including: a plasma display panel; at least one driving board to drive the plasma display panel; a chassis base located between the plasma display panel and the driving board, to support the plasma display panel, and disposed in direct contact with the driving board; and an electronic element mounted on a rear surface the driving board.

## Description

The present invention relates to a plasma display device.

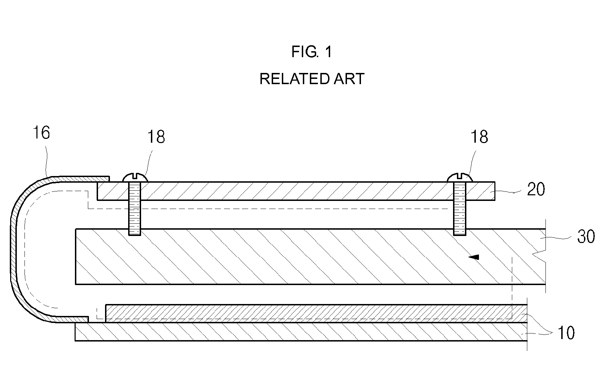

Plasma display devices are display devices that display characters or images with plasma generated by a gas discharge. As shown in FIG. 1, a plasma display device includes: a plasma display panel 10, which displays an image; a chassis base 30, which supports the plasma display panel 10; a driving board 20, which is mounted on the chassis base 30, opposing the plasma display panel 10; and a signal transmission film 16 disposed between the plasma display panel 10 and the driving board 20.

Grounding layers included in the driving board 20 are connected to the chassis base 30 with screws 18. If an area of the grounding layers is minimized, so as to reduce cost, a contact surface between the grounding layers and the chassis base 30 is reduced, thereby causing problems in that driving waveforms generated in the driving board 20 are degraded, and/or an electromagnetic interference (EMI) is increased.

A current generated in the driving board 20 returns to the driving board 20, through a loop. The loop extends through the signal transmission film 16, the plasma display panel 10, the chassis base 30, and the screws 18. The area of the loop (dotted line in FIG. 1) is relatively large. Therefore, there is a problem in that electro magnetic interface, which is in proportion to the area of the loop, increases. In addition, since the screws 18 function as inductors in a high frequency region, an impedance thereof increases. Therefore, the loop cannot be formed in a high frequency region. Accordingly, there is a need for a plasma display device, which has a large grounding layer area in the driving board 20, such that the electromagnetic interference is reduced.

Accordingly, aspects of the present invention relate to a plasma display device capable of minimizing an electromagnetic interference (EMI). The plasma display device includes: a plasma display panel; at least one driving board to drive the plasma display panel; a chassis base located between the plasma display panel and the driving board, to support the plasma display panel and the driving boards, and directly contacts surfaces of the driving board; and electronic elements mounted on a rear surface of each of the driving board, that have front surfaces that face the chassis base. A rear surface of the chassis base faces the plasma display panel and may directly contact front surfaces of the driving board.

The plasma display device, according to aspects of the present invention, further includes: a screw hole through the driving board; a screw groove, which extends through a part of the rear surface of the chassis base, which has a front surface that faces the plasma display panel; and a screw which is inserted into the screw hole and the screw groove.

The chassis base may include a groove disposed in the rear surface of the chassis base, to receive the driving board. The driving board can include: a first driving board having a surface disposed in contact with the chassis base; and a second driving board attached to the chassis base using a screw. The second driving board can be spaced apart from the chassis base.

An electronic element that is a surface mount device, may be mounted on the first driving board; and an electronic element that is an insert mount device, may be mounted on the second driving board. The first driving board and the second driving board may be connected to each other, through a cable or a signal transmission film.

Aspects of the present invention provide a plasma display device including: a chassis base; a plasma display panel supported by a front surface of the chassis base; and a driving board supported by a rear surface of the chassis base. One surface of the driving board comes into contact with the chassis base, so as to minimize a length of a current loop where a current of a driving waveform generated by the driving board, is returned to the driving board.

Additional aspects and/or advantages of the invention will be set forth in part in the description which follows and, in part, will be obvious from the description, or may be learned by practice of the invention.

These and/or other aspects and advantages of the invention will become apparent and more readily appreciated from the following description of the embodiments, taken in conjunction with the accompanying drawings of which:
FIG. 1 is a cross-sectional view illustrating a plasma display device, according to the related art;
FIG. 2 is a perspective view illustrating a plasma display device, according to an exemplary embodiment of the invention;
FIG. 3 is a cross-sectional view illustrating the plasma display device including a driving board and a chassis base, which are coupled using screws, and surfaces thereof come into contact with each other, according to an exemplary embodiment of the invention;
FIG. 4 is a cross-sectional view illustrating a plasma display device including a driving board and a chassis base, which are coupled without using screws, and
surfaces thereof come into contact with each other, according to an exemplary embodiment of the invention;
FIG. 5 is a cross-sectional view illustrating a current loop of the plasma display device shown in FIG. 3;
FIG. 6 is a perspective view illustrating a plasma display device, according to an exemplary embodiment to the invention; and
FIG. 7 is a cross-sectional view illustrating the plasma display device shown in FIG. 6.

Reference will now be made in detail to the present embodiments of the present invention, examples of which are illustrated in the accompanying drawings, wherein like reference numerals refer to the like elements throughout. The embodiments are described below in order to explain the present invention, by referring to the figures.

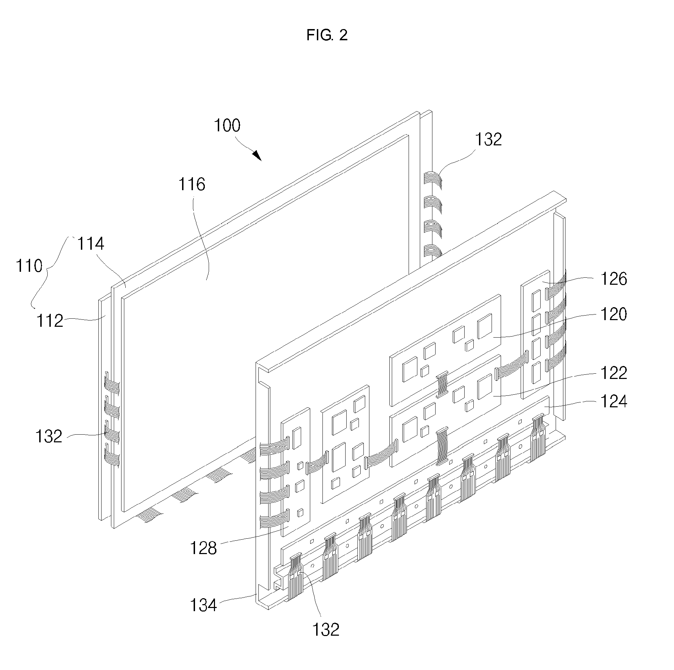

FIG. 2 is a perspective view illustrating a plasma display device according to an exemplary embodiment of the invention. As shown in FIG. 2, the plasma display device 100 includes a plasma display panel 110, a chassis base 134, and driving boards 120, 122, 124, 126, and 128.

The plasma display panel 110 displays an image using a plasma discharge. The plasma display panel 110 includes a front panel 112 and a rear panel 114, which face each other. The front panel 112 includes: a front substrate (not shown); scan electrodes (not shown); sustain electrodes (not shown) that are formed on the front substrate in parallel with each other; an upper dielectric layer (not shown) that covers the scan electrodes and the sustain electrodes; and a protective layer (not shown) that covers the upper dielectric layer. The rear panel 114 includes: a rear substrate (not shown); address electrodes (not shown) that are formed on the rear substrate and intersect the scan electrodes and the sustain electrodes; a lower dielectric layer (not shown) that covers the address electrodes; barrier ribs (not shown) disposed on the lower dielectric layer, to define a discharge space; and a phosphor layer (not shown) disposed on the barrier ribs and the lower dielectric layer.

A heat sink sheet 116 is attached on a rear surface of the plasma display panel 110. The heat sink sheet 116 absorbs heat generated by plasma display panel 110 and conducts and diffuses the absorbed heat, in a plane direction of the plasma display panel 110. The heat sink sheet 116 may be formed of a plurality of materials, such as, an acrylic-based, radiation-absorbing material, a graphite-based, radiation-absorbing material, a metal-based, radiation-absorbing material, or a carbon nanotube-based, radiation-absorbing material.

A front surface of the chassis base 134 is attached on a rear surface of the plasma display panel 110. The heat sink sheet 116 is disposed between the chassis base 134 and the plasma display panel 110, to support the plasma display panel 110. The driving boards 120, 122, 124, 126, and 128 are provided on a rear surface of the chassis base 134 and are supported by the chassis base 134. The chassis base 134 has mechanical hardness capable of supporting the plasma display panel 110 and the driving boards 120, 122, 124, 126, and 128. The driving boards 120, 122, 124, 126, and 128 can create driving waveforms.
The driving boards can be individually referred to as a power supply board 120, a logic board 122, an address buffer board 124, a sustain driving board 126, and a scan driving board 128. The power supply board 120 supplies power to drive the logic board 122, the address buffer board 124, the scan driving board 128, and the sustain driving board 126. The logic board 122 receives an image signal, generates control signals necessary to drive the address electrodes, the scan electrodes, and the sustain electrodes, and supply the generated control signals to the corresponding boards.

The address buffer board 124 is provided on an upper portion of, or a lower portion of, the chassis base 134. The address buffer board 124 supplies an address pulse to the address electrodes, during an address period. Circuit terminals of the address buffer board 124 are connected to electrode terminals provided outside the plasma display panel 110, to connect the address electrodes through the signal transmission films 132. The signal transmission films 132 can be a TCP (Tape Carrier Package) or an FPC (Flexible Printed Circuit).

The scan driving board 128 supplies driving waveforms, for example, a rising ramp pulse and a falling ramp pulse, during reset periods, a scan pulse during address periods, and a sustain pulse during sustain periods, to the scan electrodes. Circuit terminals of the scan driving board 128 are connected to electrode terminals provided outside the plasma display panel 110, which are to connect to the scan electrodes through the signal transmission films 132.

The sustain driving board 126 supplies the sustain pulse to the sustain electrodes, during the sustain periods. Circuit terminals of the sustain driving board 126 are connected to electrode terminals provided outside the plasma display panel 110, which are to connect the sustain electrodes through the signal transmission films 132.

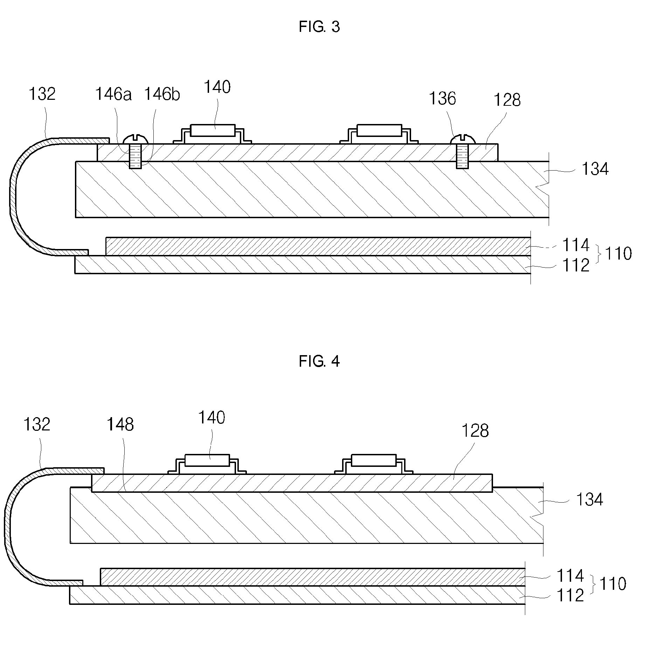

As shown FIGS. 3 and 4, a front surface of at least one of the power supply board 120, the logic board 122, the address buffer board 124, the sustain driving board 126, and the scan driving board 128, is disposed in direct contact with the rear surface of the chassis base 134. In other words one surface of any one of the power supply board 120, the logic board 122, the address buffer board 124, the sustain driving board 126, and the scan driving board 128, comes into contact with the rear surface of the chassis base 134.

As shown in FIG. 3, the scan driving board 128 is fixed to the rear surface of the chassis base 134 with screws 136. Screw holes 146a are formed in the scan driving board 128. Further, screw grooves 146b, formed in the rear surface of the chassis base 134, are disposed adjacent to the screw holes 146a. The screws 136 are inserted to the screw holes 146a and the screw grooves 146b, to couple the scan driving board 128 to the chassis base 134.

As shown in FIG. 4, the scan driving board 128 is inserted into a groove 148 in the chassis base 134. A surface area of a portion of the scan driving board 128 that is inside the groove 148, is equal to, or larger than, a surface area of a portion of the scan driving board 128 that is not inside the groove 148. In other words, about half, or less, of the scan driving board 128 is disposed inside the groove 148.

An electronic circuit element 140, which is a surface mount device (SMD), is mounted on a rear surface of the scan driving board 128, which opposes a front surface thereof that is fixed to the rear surface of the chassis base 134. The electronic circuit element 140, which is a surface mount device, can be soldered to the scan driving board 128. The solder may be, for example, a Pb-free solder.

As described above, when the scan driving board 128 is fixed to the rear surface of the chassis base 134, the contact surface between the chassis base 134 and the scan driving board 128 is increased. Therefore, a grounding layer effect of the scan driving board 128 is improved. A grounding area of the scan driving board 128 may be reduced, by decreasing a number of layers of the scan driving board 128. Accordingly, the cost may be reduced. In this case, the driving waveform, for example, the sustain pulse generated in the scan driving board 128, is supplied to the scan electrodes through the chassis base 134, without substantially degrading the driving waveform.

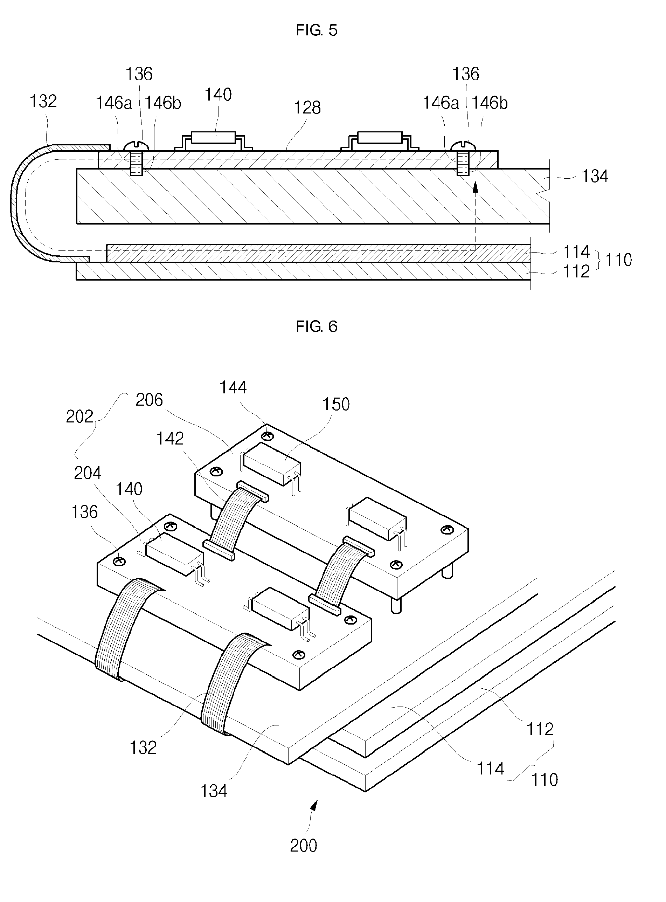

As shown in FIG. 5, when the scan driving board 128 is fixed to the rear surface of the chassis base 134, the current of a driving waveform, for example, the sustain pulse generated by the scan driving board 128, travels in a current loop (dotted line in FIG. 5) extending from the scan driving board 128, through the signal transmission films 132, the plasma display panel 110, and the chassis base 134, before returning to the scan driving board 128. An area of the loop is five times smaller than the area of a current loop according to the related art. In this case, the area where the scan driving board 128 contacts the chassis base 134 is no longer part of the current loop, thereby reducing the area of the current loop, as compared to the related art current loop that includes the space between a driving board and a chassis base. Therefore, the electromagnetic interference, which is in proportion to the area of the loop, decreases. Accordingly, it is possible to reduce the noise generated by the sustain pulse, in proportion to the amount the decreased electromagnetic interference.

In addition, when the scan driving board 128 is fixed to the rear surface of the chassis base 134, the heat generated in the scan driving board 128 is directly transmitted to the chassis base 134. The heat transmitted to the chassis base 134 may be drawn away from the scan driving board 128 by the chassis base 134, thereby improving the heat radiation property of the scan driving board 128.

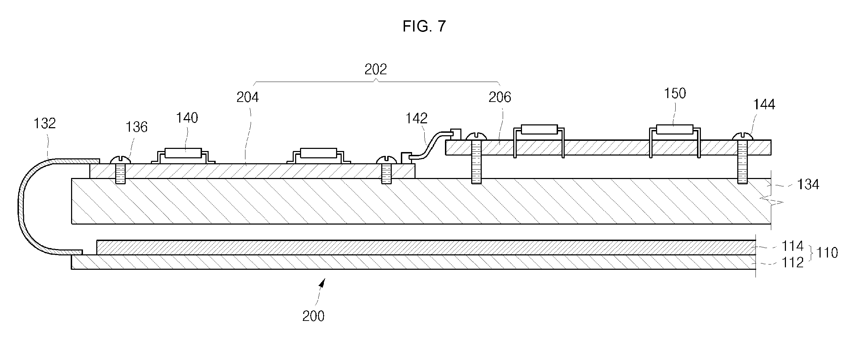

Each of FIGS. 6 and 7 are respectively a perspective view and a cross-sectional view illustrating a plasma display device 200, according to an exemplary embodiment of the invention. The plasma display device 200 includes the same configuration as the plasma display device 100, other than the display device 200 includes a scan driving board 202 that includes first and second driving boards 204 and 206. Therefore, the detailed description with respect to the same configuration will be omitted.

Further, in the plasma display device 200, the same reference numerals will be used to represent similar components used in the plasma display device 100.

The plasma display device 200 as shown in FIGS. 6 and 7, includes a plasma display panel 110 which has a front panel 112 and a rear panel 114, a chassis base 134, and, of which a scan driving board 202. The plasma display device can also include a plurality of additional driving boards (not shown).

The scan driving board 202 includes a first driving board 204, on which electronic circuit elements 140 (surface mount devices) are mounted, and a second driving board 206 on which electronic circuit elements 150 (insert mount devices) are mounted.

The first driving board 204 is fixed to the rear surface of the chassis base 134. The surface mount devices 140, among the plurality of electronic circuit elements included in the scan driving board 202, are mounted on the first driving board 204. The surface mount devices 140 are attached on the first driving board 204 through solders.

The insert mount devices 150 are not soldered to the surface of the second driving board 206. The insert mount devices 150 can be, for example, dual in-line package (DIP) type electronic circuit elements. The insert mount devices 150 are mounted on the second driving board 206, such that leads of the insert mount devices 150 penetrate the second driving board 206. The second driving board 206 can be electrically connected to the first driving board 204 through a cable 142, or with signal transmission film (not shown).

As described above, when the first driving board 204 is fixed directly to the rear surface of the chassis base 134, the contact surface between the chassis base 134 and the first driving board 204 becomes large. Accordingly, a grounding effect of the first driving board 204 may be increased, and the number of layers of the first driving board 204 may be reduced, due to the improved grounding effect. Therefore, it is possible to reduce the grounding area of the first driving board 204, to reduce costs. Further, when the first driving board 204 is fixed to the rear surface of the chassis base 134, the area of a current loop formed by a path of a current to be returned to the first driving board 204, is decreased, as compared to the related art. Therefore, the amount of radiation of the electromagnetic interference, which is proportional to the area of the loop, decreases. Accordingly, it is possible to reduce noise, due to electromagnetic interference from a sustain pulse traveling down the loop.

As described above, in a plasma display device, according to aspects of the invention, it is possible to decrease an amount electromagnetic interference created by waveforms, by minimizing an area of a current loop. It is also possible to maximize a grounding area of a driving board by using the chassis base, and it is also possible to decrease a number of layers in the driving board.

Although a few embodiments of the present invention have been shown and described, it would be appreciated by those skilled in the art that changes may be made in this embodiment without departing from the principles of the invention, the scope of which is defined in the claims.

## Claims

1. A plasma display device comprising:
a chassis base;
a plasma display panel supported by the chassis base and adjacent to a front surface of the chassis base;
a first driving board having a front surface in contact with a rear surface of the chassis base, to drive the plasma display panel; and
an electronic element mounted on a rear surface of the first driving board.

2. The plasma display device as claimed in claim 1, wherein the electronic element is a surface mount device.

3. The plasma display device as claimed in claim 1 or 2, further comprising at least one screw to attach the first driving board to the chassis base, and
wherein the at least one screw extends through the first driving board into the rear surface of the chassis base.

4. The plasma display device as claimed in claim 1, 2 or 3, wherein the rear surface of the chassis base has a groove defined therein; and the first driving board is disposed in the groove.

5. The plasma display device as claimed in claim 4, wherein the first driving board is disposed in the groove such that one surface of the first driving board contacts the groove.

6. The plasma display device as claimed in any one of the preceding claims, further comprising:
at least one screw; and
a second driving board connected to the chassis base by the at least one screw.

7. The plasma display device as claimed in claim 6, wherein a front surface of the second driving board faces and is spaced apart from the rear surface of the chassis base.

8. The plasma display device as claimed in claim 6 or 7, further comprising an insert mount device mounted to a rear surface of the second driving board.

9. The plasma display device as claimed in claim 6, 7 or 8, further comprising one of a cable or a signal transmission film, to connect the first driving board to the second driving board.
